Europäisches Patentamt

European Patent Office

Office européen des brevets

(19)

(11) Publication number: **0 002 339**
**B1**

## EUROPEAN PATENT SPECIFICATION
(12)

(45) Date of publication of patent specification: **30.11.83**

(21) Application number: **78300667.9**

(22) Date of filing: **24.11.78**

(51) Int. Cl.³: **G 06 F 3/14** //G06F3/153, G09F9/30

(54) Improvements relating to data display techniques.

(30) Priority: **28.11.77 US 855128**
**28.11.77 US 855522**

(43) Date of publication of application:
**13.06.79 Bulletin 79/12**

(45) Publication of the grant of the patent:
**30.11.83 Bulletin 83/48**

(84) Designated Contracting States:
**DE FR GB**

(56) References cited:
**DE - A - 2 605 468**
**FR - A - 2 334 960**
**US - A - 3 686 662**
**US - A - 4 068 310**

(73) Proprietor: **GOULD INC.**
**10 Gould Center**
**Rolling Meadows Illinois 60008 (US)**

(72) Inventor: **Bowers, John J.**
**4509 Coddingville Road**
**Medina Ohio 44256 (US)**
Inventor: **Lecklider, Thomas H.**
**12 Pynchon Paddocks Wright's Green**
**Little Hallingbury Stortford, CM22 7RJ. (GB)**

(74) Representative: **Milhench, Howard Leslie et al,**
**A.A. Thornton & Co. Northumberland House**
**303/306 High Holborn**
**London, WC1V 7LE (GB)**

Courier Press, Leamington Spa, England.

## Improvements relating to data display techniques

This invention concerns improvements in or relating to data display techniques, and more particularly concerns the interpolation of data for activating elements of a display matrix which have no counterpart in the actual input data thereby to fill in and make continuous parts of the display which otherwise would be vacant.

From DE—A—2 605 468 a display system is known which can display not only assembled data but also data interpolated from said assembled data. More particularly DE—A—2 605 468 shows a system for interpolating data to be displayed in a display matrix comprising a plurality of data display lines each comprised of a plurality of selectively addressable data display elements, the data being assembled in a plurality of lines of data to be displayed sequentially in respective data display lines of the display matrix and each line of data comprising the data to be displayed selectively in the plurality of data display elements of the respective data display line, said system comprising means arranged to derive additional data from said assembled data, and means to incorporate said additional data into the assembled data to be displayed therewith in said display matrix, said additional data corresponding to data display elements such as to interpolate with data display elements corresponding to the assembled data so that when all the data is displayed, a logical continuum of addressed data display elements is provided between data display elements which are addressed by data of said assembled data and which are located in spaced apart display lines of the display matrix in positions which are next adjacent to one another relative to the respective display lines.

In operation of the system of DE—A—2 605 468, the plurality of data lines to be displayed are interrogated sequentially. As each data line is addressed for display, the data items of the data line are recorded in a shift register storage device which thus accumulates a record of all the data display points in the successive incoming lines of data. In principle, this record accumulated from preceding lines of data is displayed with ever succeeding data line, but to avoid display of all data points within the envelope defined by the signal waveform, the shift register output is coupled to the display device by means of a pair of monostable circuits which pass to the display device signals representative only of the start and end of the data word outputted by the shift register. The contents of the shift register are recirculated in synchronisation with the interrogation of successive lines of data.

Whilst the system described in DE—A—2 605 468 provides a simple means of interpolating data for display of a single item such as a signal waveform, it is not capable of providing interpolated data for simultaneous display of a multiplicity of such items; its simple principle of operation, as outline above, is not sufficiently sophisticated to accommodate multiple displays. As is well known, modern display devices commonly provide the facility of simultaneously displaying more than one item and there has thus existed a need for a data interpolation system which can be used with such modern display devices.

In accordance with the present invention a system of the aforementioned type for interpolating data to be displayed in a display matrix is characterized in that the means for deriving additional data is operable sequentially on each said line of data to be displayed for identifying for each said line of data the one or more positions therein whereat an addressed data display element would next adjoin a data display element not so addressed if the respective line of data were displayed in a data display line of the display matrix and for generating for each said line of data additional data representative of such identified positions, in that storage means is provided for storing said generated data, and in that said means to incorporate said additional data into the assembled data comprises means operable sequentially on each said line of data to be displayed to incorporate therein the data from the storage means and logic means to inhibit such incorporation whenever an identified data display position represented by a generated data item bears a predetermined relationship with an addressed data display element position in the respective data line.

In a typical raster scan type cathode ray tube display for example, an image is generated by allowing a scanning electron beam to strike the phosphor on the face of the cathode ray tube only at selected locations and by blanking off the electron beam as it scans over all other locations. To maintain an image generated in this manner on the cathode ray tube it is necessary for the electron beam continuously to repeat the scanning of the same data. To allow this repeated scanning, the data is normally stored in a memory. In the past, the memory, in order to be able to address any point on the face of the cathode ray tube, had to contain M storage positions, where M is equal to the number of scan lines per frame times the number of elements of resolution in one scan line. A display, for example, of 240 visible scan lines and 256 resolvable elements per scan line, that is about half the number of points of a standard TV screen, would require 240×256 or 61,440 addressable storage elements. If the beam is to be switched on or off at each location, storage elements are only required to be single bit memories.

By virtue of the present invention it has been found that in the case for example of a display of a waveform which is single valued in one direction, i.e. perpendicular to the scan line, the number of storage positions provided in the memory need only be equal to the number of resolvable elements in one scan line with each storage position being large enough to contain data such as to provide a unique indication as to which scan line of the display is to be addressed. In the example given above of 240 visible scan lines and 256 resolvable elements, 256 storage positions would be required and each of the storage positions would have to be able to uniquely address any one of the 240 lines. This is to say, each storage position must have the ability to take any one of 240 different values. In the case of a solid state memory made up of memory bits, each bit having two states, each memory position must have N memory bits where $2^N \geq$ number of scan lines. To be able to address 240 different scan lines, eight memory bits are needed. Thus, 256 memory positions, each with eight bits, requires only 2,048 bits of memory as opposed to the 61,440 bits required for a conventional 256×240 bit matrix memory. Of course, the present invention applies to displays of any size.

If there is only one memory storage position for each data display position along the raster scan lines, then the data at any memory storage position can be displayed on only one scan line. Such a display on a cathode ray tube would appear as a series of disjointed points or horizontal line segments; vertical lines could not be displayed. The present invention, in a specific example thereof, without increasing the amount of memory required, generates vertical lines to connect each of the points or horizontal line segments. Specifically, this example of the invention is arranged to receive a line of data detect the starting and stopping positions of data in the received line of data, initiate the generation of a rise line at a position corresponding to a detecting starting position and a fall line at a position one display element past a detected stopping position, receive a second line of data, terminate said rise line if in the second line of data there is data in the position preceding the position of said rise line, terminate said fall line if in the second line of data there is data in the same position as the fall line, detect the starting and stopping positions of data in said second line of data, initiate a rise line in the position corresponding to the starting position of data in said second line of data unless said position also corresponds to the position of said fall line, initiate a fall line one position past the stopping position of the data in the second line unless said position one space past stopping position corresponds to a rise line, and produce an output indicative of the data, each rise line, and fall line, this sequence of operations being repeated for successive lines of data. Thus, in one of its applications, the present invention allows any single valued function such as a sine wave, a series of step functions, or an exponential waveform, to be stored as discrete points or horizontal line segments, yet to be displayed as a continuous function.

The invention, together with objects, features and advantages thereof, will best be understood from consideration of the following detailed descriptions of two exemplary embodiments of the invention which are illustrated in the accompanying drawings wherein:—

Figure 1 shows the circuit diagram of a first exemplary embodiment of the invention;

Figure 2 shows 20×20 display matrix in which display elements corresponding to actual data values are marked with a star and display elements depicting interpolated connecting data are marked with a slash;

Figures 3 to 8 show the pulse trains that would appear at various marked points in the circuit of Figure 1 when data corresponding to the fifth, sixth through ninth, tenth, eleventh through fourteenth, fifteenth, and sixteenth through twentieth scan lines, respectively, of Figure 2 are processed;

Figure 9 shows the circuit diagram of a second exemplary embodiment of the invention;

Figure 10 is a representation of data points in a display matrix;

Figure 11 is a graphical representation of the data points of Figure 10 with vertical connecting data points interpolated in accordance with the invention; and

Figure 12 is a chart showing the pulse trains appearing at various marked points within the circuit of Figure 9 when the data of Figure 10 is processed therethrough.

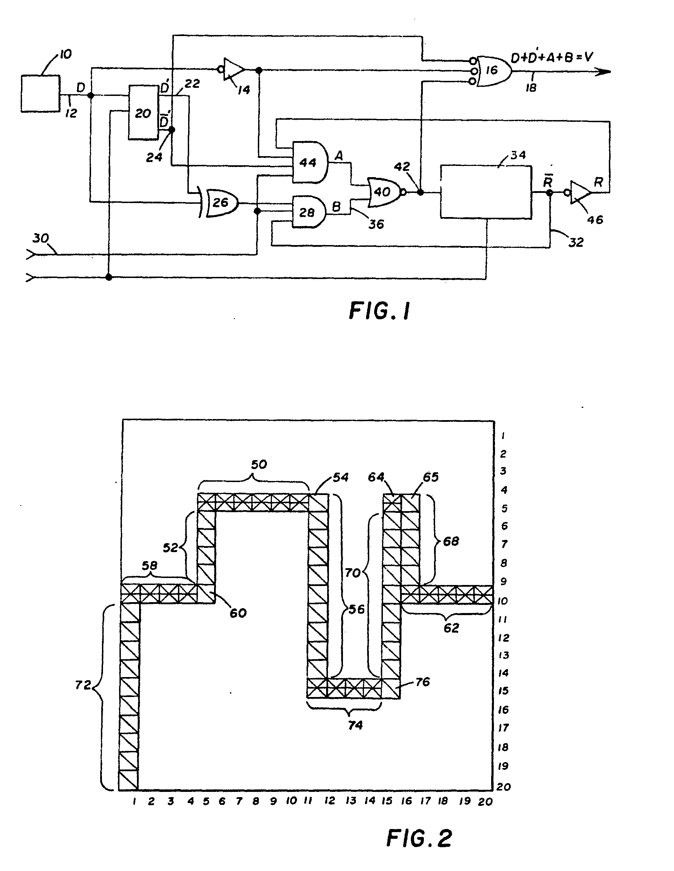

The embodiment of the invention hereinafter described with reference to Figures 1 to 8 is adapted to interpolate data assembled for display in a cathode ray tube display matrix comprising a plurality of individually addressable horizontal scan lines each considered as comprising a plurality of individually addressable display elements or points spaced along the length of the scan line. Data is stored in a memory having a number of individually addressable word storage locations corresponding to the number of display elements in a scan line, each of the word storage locations having a bit capacity capable of providing a unique data bit combination address for each of the scan lines. The memory is scanned by serially addressing the word storage locations each time interrogating the word storage location as regards its scan line information content so that there is outputted to the circuit according to the invention a series of pulse trains each corresponding to a respective scan line and each providing information for selectively energizing the display elements in that scan line. By this means, the data in the memory is displayed as a series of horizontal lines on the display matrix; the function of the circuit according to the invention is to interpolate the data from the memory so as to display vertical interconnecting lines at those points of the display where the displayed function would otherwise show a discontinuity corresponding to the line scan information of two adjacent word storage locations of the memory being different.

Referring to Figure 1, the memory is shown at 10 and is connected as shown to provide output trains of pulses D to flip-flop 20 which also receives a clock input. Flip-flop 20 provides one output D′ which corresponds to the input D delayed by one clock pulse, and a second output $\overline{D}'$ which is the inverse of D′. An EXCLUSIVE-OR gate 26 is connected to receive inputs from the memory 10 and from the D′ output of flip-flop 20 and to provide a corresponding input to AND gate 28 which receives further inputs from a clear line 30 and from a line 32. A second AND gate 44 is connected to receive the $\overline{D}'$ output of flip-flop 20, the clear signal from line 30, a $\overline{D}$ input from memory 10 via an inverter 14 and a recirculatory signal R the purpose of which will be explained hereinafter. The outputs A and B respectively of AND gates 44 and 28 are coupled to provide inputs to NOR gate 40 which provides an output to a shift register 34. An output 18 to the cathode ray tube display is taken via OR gate 16 which has inverting inputs coupled to the $\overline{D}'$ output of flip-flop 20, to the output of inverter 14 providing $\overline{D}$, and to the output of NOR gate 40.

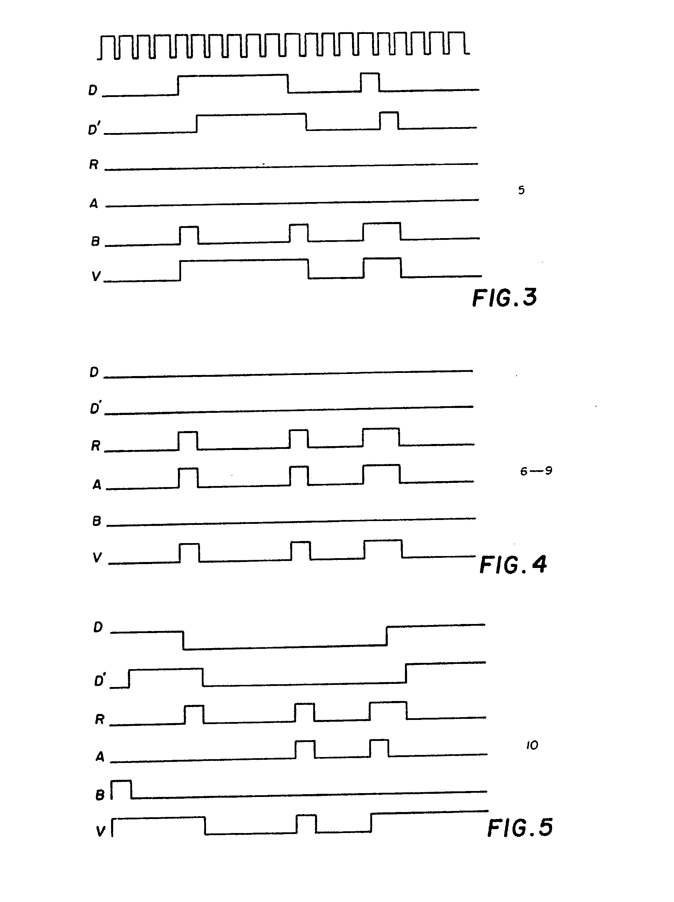

As mentioned above the circuit illustrated in Figure 1 is designed to generate vertical connecting lines between horizontal data lines. In operation, the circuit will determing the beginning and end of each horizontal line of data. Although there are many ways of accomplishing this, the circuit of Figure 1 is arranged to delay the line of data received from the memory by one clock pulse and compare the delayed line of data with the actual line of data. As will be seen (note Figure 3, lines D and D′), only a position corresponding to the first point of a line of data and a position one clock pulse past the last point of actual data will have a high pulse in one of these two lines and low in the other. By virtue of EXCLUSIVE-OR gate 26, a line of data with high pulses only at the beginning and end of the data line can be generated. This line of interpolated data is then stored in shift register 34 which has the same number of storage positions as there are display elements in a scan line.

The determination of the beginning and end of a horizontal line of data is then used in subsequent scan lines to generate a vertical line below the beginning and end of the horizontal line or individual data point. In the described embodiment, the data stored in the shift register is recirculated, in synchronisation with the clock pulse, through a recirculating loop during the following scan line. At some point in the recirculating loop, a connection is made to the video display so that the vertical connecting line data generated by the EXCLUSIVE-OR gate 26 can be displayed in the subsequent scan line.

When the vertical connecting line descends to another scan line which has an end of a horizontal line of data or individual point of data that intersects or connects with the vertical connecting line, the connecting line is cut off. Because the described embodiment extends each horizontal line or individual data point by one position when it creates the delayed line of data, the vertical connecting line is recirculated until it would overlap an actual data point or a delayed data point. When this coincidence occurs, the two horizontal lines have been connected and the data which causes the vertical line is removed from the recirculation path. In the Figure 1 embodiment, the recirculating connecting line signal from the shift register 34 is compared with data $\overline{D}$ from memory 10 and with data $\overline{D}'$ delayed by one clock pulse from flip-flop 20 in AND gate 44 to check for this coincidence. If there is a high signal on the $\overline{D}$ data or the $\overline{D}'$ data in the same position as a high pulse from the shift register 34, then the high pulse from the shift register is removed. Thus, the vertical connecting line is terminated.

A further horizontal line of data or a further data point read into the circuit should not generate a vertical connecting line below one of its end positions if a vertical connecting line has already been generated above it. For example, in Figure 2 a vertical line extending below the first data point of line 74 should not be created. That is, the circuit must be able to ascertain whether a data point has already been connected to a data point in a higher scan line, or whether a descending vertical must be generated to connect it to a data point in a lower scan line. Although there are many ways in which this could be done, the described embodiment does this by comparing the data indicative of the beginning and end of a horizontal line of data, i.e., the output from the EXCLUSIVE-OR gate 26, with the contents of the shift register at the corresponding position. If there is already data in the shift register at the position corresponding to an end of a horizontal data line, AND gate 28 blocks the passage of the high pulse indicative of an end of a horizontal data line from the EXCLUSIVE-OR gate 26 to the shift register 34. In this manner, the signal indicative of an end of a horizontal line is barred from being placed in storage in shift register 34.

The specific operation of the circuit of Figure 1 can best be illustrated by following through the generation of an exemplary visual display. By way of example, the generation of the 20 by 20 display of Figure 2 is explained below. The display elements marked with a star correspond to actual data values stored in memory 10, and the display elements marked with a slash correspond to the connecting data interpolated by the circuit. Figures 3 to 8 illustrate the pulse trains which appear at various positions in the circuit; thus D represents the data from memory 10 on line 12, D' represents this data delayed by one clock pulse as it would appear on line 22, R represents data stored in the shift register as it would appear emerging from inverter 46, A represents the data emerging from AND gate 44, B represents the data emerging from AND gate 28; and V represents the output on line 18 which connects to the video or other display unit.

Looking to Figure 1, the memory 10 contains one storage word for each element of resolution along a raster scan line. Each storage word is made up of a sufficient number of bits for each one of the raster scan lines in a frame to be uniquely addressed. The number of bits per storage word is the power to which 2 must be raised to have a value equal to or greater than the number of scan lines. In the example illustrated in Figure 2, a 20 by 20 display screen is shown, i.e., there are 20 scan lines per frame and 20 resolvable display elements per scan line. In this example, there would be 20 storage words, each storage word having five bits of information. If only four bits were used ($2^4=16$) all 20 scan lines could not be uniquely addressed because each storage word could only take on sixteen different magnitudes.

Each of the 20 storage words is addressed, one at a time in sequence with the clock pulses to generate a series of high and low pulses out of memory 10 on line 12 into the data interpolation circuit. If none of the 20 storage words in the memory has a magnitude corresponding to the first scan line, then a line of 20 low pulses is clocked out on line 12. All values being low, no display will appear on the cathode ray tube.

In the example of Figure 2, there will be no data read until the fifth scan line. In the fifth scan line, the fifth, sixth, seventh, eighth, ninth, tenth, and fourteenth storage words each have a magnitude corresponding to the fifth scan line, i.e., fifteen lines from the bottom of the screen. Accordingly, the series of clocked high and low pulses on line 12 will appear as four low pulses followed by six high pulses followed by four low pulses, one high pulse and five low pulses as is shown in Figure 3 line D. This pulse train will be fed into inverter 14 where each high will be turned to a low and each low to a high. From inverter 14 the signals pass to OR gate 16 which has inverting inputs such that each high will now be turned back to a low and vice versa. An OR gate with inverting inputs in logic is the equivalent of a NAND gate, which is the gate that would normally be used in building the circuit. The output on line 18 to a cathode ray tube will then cause the fifth through tenth and fourteenth phosphor display element in the fifth scan line to be illuminated.

Further, this train of pulses will be fed to D type flip-flop 20. Flip-flop 20 has two outputs. The first, D', is the same as the input line of pulses except that each pulse is delayed by one clock pulse. That is, instead of the fifth through tenth and fifteenth pulses being high, the sixth through eleventh and sixteenth output pulses from flip-flop 22 are high and the rest are low as illustrated in Figure 3, line D'. Flip-flop 20 has a second output 24 which is the inverse of output 22, i.e. each high on 22 is low on 24 and each low on 22 is high on 24.

Output 24 is also fed to NAND gate 16. This would have the effect, in the example, of creating positive output pulses for phosphors 6 through 11 and 16 as illustrated in Figure 3, line V. The net effect of this is to extend each data point of a data line by one element. D', that is the input data delayed by one clock pulse signal which appears on line 22, and the input data signal D from line 12 are both fed to EXCLUSIVE-OR gate 26. EXCLUSIVE-OR gate 26 will produce a high output pulse whenever the pulse from data D is high and the corresponding pulse from data delayed by one clock pulse, D', is low, i.e., at the beginning of a horizontal line of data, or when the pulse on data D is low and the corresponding pulse on data delayed by one clock pulse D' is high, i.e. one clock pulse past the end of a horizontal line of data.

The output of EXCLUSIVE-OR gate 26 goes to AND gate 28 as does a signal on "clear" line 30 which will always be high except at those times when it is desired to clear the data and restart. Also put into AND gate 28 is the signal $\bar{R}$ on line 32. $\bar{R}$ is the output of shift register 34. Thus, at each clock pulse there will be an output B on line 36 only if the input data and the data delayed by one clock pulse in the corresponding position are one high and one low and when there is no data already present in the shift register at this position. In the example, then, the output B in the fifth line would consist of four low pulses, one high pulse at position 5, low pulses at positions 6 through 10, one high pulse at position 11, low pulses at positions 12 through 14, two high pulses in positions 15 and 16, and low pulses to the end of the scan as is illustrated in Figure 3, line B. This data B on line 36 is fed into NOR gate 40 which conceptually can be thought of as an OR gate with an inverter on its output. Data on line 42 would be fed into 20 bit shift register 34 where it would be stored in inverse form and to NAND gate 16 which would again produce signals indicating that the phosphor at positions 5, 11, 15 and 16 of the scan line should be illuminated.

Thus, through gates 26, 28 and 40 a signal indicative of the beginning and end of each data point or line of data within a raster scan line are determined and the information stored in shift register 34.

The data in shift register 34 is recirculated so that the data stored in it will be displayed on the next raster scan. The recirculation path is through AND gate 44 which removes data from the recirculation at appropriate times. AND gate 44 has a first input connected to inverter 46 which inverts the output of the shift register 34, i.e. supplies a series of high and low pulses from shift register 34 which were fed into the shift register from NOR gate 40 in the preceding raster scan line. In the present example, the line currently in discussion, line 5, is the first line with data on it. Thus, the shift register had been empty of data until this time so the signal train R from the shift register 34 via inverter 46 is a series of 20 low pulses. A second input to AND gate 44 is from inverter 14 which supplies the inverse of the input data D. A third input is from output 24 of flip-flop 20 which supplies the inverse of the input data delayed by one clock pulse. The final input to AND gate 44 is from clear line 30 which, as indicated above, during normal operation is always high. The output, A, from AND gate 44 will only be high if R is high and on the corresponding clock pulse there is no data coming in on line 12 nor was there any data preceding clock pulse on line 12. Thus, the data in shift register 34 will continue to be recirculated through AND gate 44, through NOR gate 40, and back into shift register 34 in the same position until there is a high in the string of values D or D' at the corresponding clock pulse. In this manner, a descending display line is terminated when it meets an adjacent data point.

Now going to the sixth line of Figure 2, it will be seen that none of the 20 storage words in the memory 10 has an output on this raster scan line so that the data train D on line 12 will consist of a string of 20 low pulses as illustrated in Figure 4, line D. Thus, the line through gates 14 and 16 will produce no highs on line 18. Similarly, the train of pulses from flip-flop 20 on data delayed by one clock pulse on line 22 will similarly be a string of 20 zeros as illustrated in Figure 4, line D', while the inverse of D delayed by one clock pulse on line 24 will be a string of 20 high pulses.

EXCLUSIVE-OR gate 26 will have low pulses applied to both its inputs to all 20 clock pulses of this scan line. Accordingly, its output will be low for the entire scan line as will AND gate 28, see Figure 4, line B.

It will be remembered that in the preceding line, shift register 34 had data entered into it in the 5th, 11th, 15th and 16th pulse positions. Accordingly, gate 44 will have a string of 20 high pulses applied on its second input, i.e., the inverse of the input data, and on its third input, i.e., the inverse of the input data delayed by one line, but on its first input, it will have a low value from the shift register 34 for the first four values then a high on the 5th, 11th, 15th, and 16th clock positions. The output will be the same as this input. The output will be fed through NOR gate 40, which inverts the output, fed onto line 42, see Figure 4, line A, and both restored in the shift register 34 and fed to NAND gate 16 to produce high output pulses on scan line 18 at the 5th, 11th, 15th and 16th clock pulse positions as illustrated in Figure 4, line V.

In the example of Figure 2, the same events will occur in scan lines 7, 8 and 9 as in scan line 6.

In the tenth line, the data stored in the 20 storage words of memory 10 has a magnitude corresponding to the tenth line in data positions 1, 2, 3 and 4 and 16, 17, 18, 19 and 20 as illustrated in Figure 5, line D. Thus the line through gates 14 and 16 provide high output signals in these nine clock pulse positions on output line 18. Additionally, the output on 24 of flip-flop 20 will cause gate 16 to supply a high output pulse to the 5th clock pulse position, and were the 21st position not cut off would have supplied an additional high pulse there also.

EXCLUSIVE-OR gate 26 will produce a high output pulse in the 1st, 5th, and 16th positions. AND gate 28 receives high inputs from EXCLUSIVE-OR gate 26 only on the 1st, 5th and 16th clock pulse positions. The shift register signal R is high in the 5th and 16th positions from the 9th scan line. Thus $\bar{R}$ is low in the 5th and 6th positions. Accordingly, the only output from AND gate 28 is a high in the 1st clock pulse position with positions 2 through 20 low as illustrated in Figure 5, line B. Thus, it can be seen that these two additional lines of data points have produced the input to shift register 34 which is required to cause a vertical connecting line in the first element of the scan line only. No other vertical lines will be extending below any of the other data points read in on line 10.

Now looking to the recirculate line, AND gate 44 has an input signal R which is high only in positions 5, 11, 15 and 16 as illustrated in Figure 5, line R. In the 5th position, it will be noticed that data inverse delayed by one clock pulse is low. Accordingly, the vertical line 52 of display points that have been generated by shift register 34 is cut off. Looking to position 11 it will be noted that the data inverse and data delayed by one clock pulse inverse are both high. Accordingly, descending line 56 will be recirculated to the shift register 34 and will be continued in subsequent lines. The same is true for position 15. In position 16, however, data inverse is low. Thus, descending line 68 is also cut off. The composite output of AND gate 44 is illustrated in Figure 5, line A.

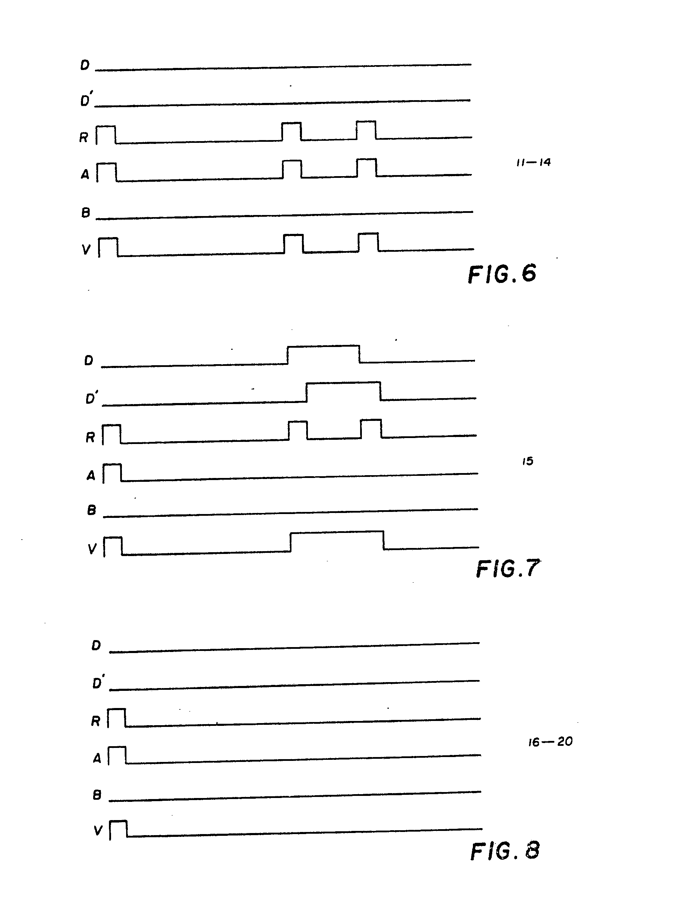

Similarly on scan lines 11, 12, 13 and 14, there will be no data or data delayed by one line. The only output will be from the data re-circulating through shift register 34 on the path through AND gate 44 which causes high output pulses on line 18 in positions 1, 11 and 15. Thus causing descending lines 56, 70 and 72 to continue downward. See Figure 6.

Upon reaching scan line 15, data point 74 is read in from memory 10 in the 11, 12, 13 and 14th positions. See Figure 7. This data will similarly cause lines 56 and 70 to be terminated. And only the line 72 at first position will be continued all the way to the bottom of the screen.

Thus, by reading only the twenty data points corresponding to the display elements marked with a star, in a memory or other data handling circuit, the circuit of Figure 1 is able to generate all the connecting data necessary to turn the display into the continuous function of Figure 2.

Many alternatives are available to the circuit of Figure 1. For example, it will be noted that from scan line 16 to the end of Figure 2, the circuit, with the exception of position 1, is in the same state as at the beginning of the display generation. Thus an additional single valued function could be displayed on the remaining scan lines. If a display of sufficient size were used and the functions to be displayed were not allowed to meet or cross, a plurality of functions could be made continuous and displayed simultaneously. For example, the top half of the display could be a reference function and the lower part one or more test results.

The data coming through EXCLUSIVE-OR gate 26 and AND gate 28 supplies the recirculate data to shift register 34 and also contributes to the output on line 18. However, it will be noticed that this contribution A to the output is always redundant with data from line 24 or on the line through gates 14 and 16. Accordingly, contribution to the output signal from the recirculate line can be taken from between AND gate 44 and NOR gate 40, fed through an inverter, and to NAND gate 16. Another alternative is to sample the recirculated data as it emerges from shift register 34 at line 32. This will cause redundant data at the intersection of a vertical and horizontal line, such as grid point 60 of Figure 2, however, the output on line 18 will be unchanged. Other changes include replacing NAND gate 16 with an OR gate (without inverting inputs), connecting line 22 rather than 24 to the OR gate, moving inverter 14 to the input of AND gate 44 and connecting the output of AND gate 44 to the third input of the OR gate. There are so many other minor modifications which would be obvious to the appropriately skilled reader and which can be made to create redundant data or eliminate redundant data, that it is impractical to list them all herein.

Still other slight modifications can be made which will modify the display so slightly that its utility is not degraded and it still appears as a continuous function. For example, if line 24 were disconnected from NAND gate 16, only shifted data points at the right end of a horizontal line with the vertical connecting line extending from above, such as grid point 60, would be lost. This corner point would be regained by shifting the input to NAND gate 16 from line 42 to line 32 but at the expense of losing the corner point at the right end of a horizontal line from which point the vertical connecting line extends down such as grid points 54 or 66.

Other circuits can be added to remove the vertical line 72 in Figure 2 or the display means could be adjusted to display only positions 2 to the end, i.e. drop position 1.

It will be appreciated that the memory 10 need not be digital. Instead, an anlog memory could be used. Then the analog voltage storage corresponding to each position could be addressed one at a time and the voltage at each position compared to a voltage range corresponding to the particular scan line. In a system which has a continuous input for each position, a memory is not even needed. For example, a system with a set of five detectors which generate an output voltage indicative of a physical property, such as thickness of a work piece, could produce a set of analog voltages as long as the work piece remained adjacent the detectors. This removes the need for a memory. To produce a 20 by 20 display from such a system, the analog voltage outputs, whether directly from the detectors or from a memory, would be addressed sequentially each for four consecutive clock pulses to stretch each piece of data to four positions. Each addressed output voltage would be compared with a range of values corresponding to the scan line being generated and if within the range a high output produced. This would produce a display of five horizontal line segments which the present invention would join into a continuous function for easier viewing.

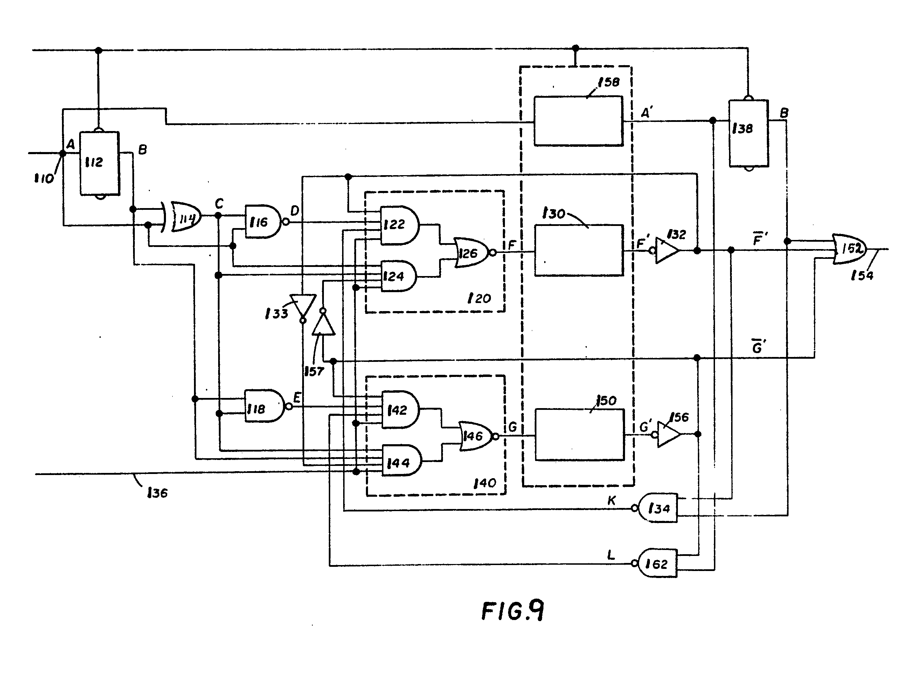

A second embodiment of the invention which is arranged to perform a function similar to that performed by the first embodiment above described is shown in Figure 9. The construction and operation of the second embodiment will be apparent from the following.

Looking to Figure 9, data in the form of a series of high and low pulse trains, the number of pulses in each train corresponding to the number of resolvable display elements in one scan line of a data display matrix, come into the circuit on line 110. This series of pulses is designated as A and corresponds to the pulses from memory 10 in the embodiment of Figure 1. The data A is fed into a flip-flop switch 112 which is sequenced by clock pulses. An output B from flip-flop switch 112 is the data A delayed by one clock pulse.

Data A and B are both fed to an EXCLUSIVE-OR gate 114. The series of output pulses from gate 114, designated C, are high whenever one, but not both, of the pulses in the corresponding clock position of signals A and B is high. C is low whenever the pulses in the corresponding positions in A and B are the same, i.e., either both are high or both are low.

Signals C and A are fed to the inputs of inverting AND gate 116. The output signal D is low whenever the corresponding pulses in A and C are both high, otherwise the output pulse of D is high. It will be noticed that D will be high in all positions except those corresponding to a single high pulse in the pulse train A or in the position corresponding to the first high pulse in a string of sequential high pulses in pulse train A. Thus, the signal D marks the position at which the circuit will generate a rise line to connect the actual data points. Similarly, signals C and B are fed to inverting AND gate 118 to create an output signal E. Signal E will indicate the position of a fall line. Signal E will be high for all inputs except for those pulses which are in the position corresponding to the last high pulse in a line of high pulses in signal B or corresponding to a single high pulse in signal B. Thus, the fall line is created one clock pulse past the end of a series of high clock pulses in pulse train A.

Going back to the rise generator circuit, there is an AND-OR-INVERT gate 120 which is composed of two AND gates 122 and 124 and an inverting OR gate 126. The similarity of this structure to the gates 44, 28, 40 of Figure 1 will be noted. One input to AND gate 122 is the pulse train F′ stored in shift register 130 from the last scan line which has been inverted with an inverter 132. A second input is signal D from inverting AND gate 116. A third input is a signal K from an inverting AND gate 134 (which serves to compare the data from shift register 130 indicative of the rise line stored from the preceding scan line with input data stored in a shift register 158 from the previous scan line) which will be low only when the rise line is to be terminated. Signal K will be explained in more detail later. A fourth and final input to AND gate 122 is a clear signal from clear line 136. The clear signal will be high during all normal operations of the circuit and will only go low when it is desired to erase or reset the circuit. AND gate 122, then, passes the rise indication signals on through, except in two situations. The first situation is when there is already data stored in shift register 130 in the position corresponding to the rise line. The second situation is when there is both a low signal in the corresponding position in shift register 130 and there is a high signal from a flip-flop 138. It will be seen that the signal from flip-flop 138, designated B′, represents the actual input data A from the preceding scan line delayed by one clock pulse. Thus, the rise line will not be generated if there is a high signal in the preceding scan line in the position one clock pulse before the proposed rise line position.

AND gate 124 also has four inputs. The first is signal A, the second signal C, the third is the inverse of the output G′ of a shift register 150 (which will be high in all positions except the position in which there is a fall line being generated), and the fourth is the clear signal. AND gate 124, then, will generate a high output pulse only when the corresponding position of signal A is high and signal B is low and the fall line signal G′ is high.

Inverting OR gate 126 combines the outputs of AND gates 122 and 124 to produce a signal F which will be high under all conditions except in the pulse position corresponding to the position of a rise line, either being started with this line of data or being recirculated from a previous line of data.

The signal F is then stored in shift register 130 which has one storage position for each element of resolution of a scan line. Shift register 130 is sequenced by a clock pulse generator such that in each scan line the data already in shift register 130 is stepped out one pulse at a time and sequenced with the new input data arriving on line 110. Thus, the output F′ of shift register 130 is a pulse train one scan line delayed from the data being read. The data from shift register 130 passes through inverter 132, from which the information is recirculated back to AND gate 122 and on to OR gate 152. This will create an output signal on line 154. In the clock pulse position corresponding to the position (if any) of a rise line in the last scan line, there will be a high pulse.

In the fall generator circuit, AND-OR-INVERT gate 140 is made up of an AND gate 142, second AND gate 144, and an inverting OR gate 146. Just as in AND-OR-INVERT gate 120, the two AND gates each ascertain whether or not one of the two alternative conditions are met for generating/terminating a fall line. The two conditions are combined in inverting OR gate 146. This output, designated signal G, will have a high output pulse in the position corresponding to the position in which a fall line is to be started in the next scan line. In the next scan line, the output G′ from shift register 150 is passed through inverter 156 and recirculated back to AND gate 142 as well as passed to OR gate 152 to create an output on line 154 which has a high pulse at those positions corresponding to a fall line stored in shift register 150.

The real data A coming in one line 110 is also fed to shift register 158. The real data is stored there for one scan and is fed out of shift register 158 in the subsequent scan line. This real data delayed by one scan line is designated as data A′. The data A′ goes to flip-flop 138, discussed above, where it is delayed by one clock pulse to produce signal B′. The signal B′ is fed to inverting AND gate 134, discussed above, and to OR gate 152. This produces output pulses on line 154 which are high in positions corresponding to one clock pulse past high pulses in the actual data A read in the preceding scan line. The output A′ from shift register 158 is further fed to inverting AND gate 162 which produces a signal L analogous to signal K, discussed above, in the rise line generating situation. Signal L stops the recirculation of fall line data back into shift register 150 when the fall line reaches a high pulse in the data A′ in the same position. This cuts off fall lines.

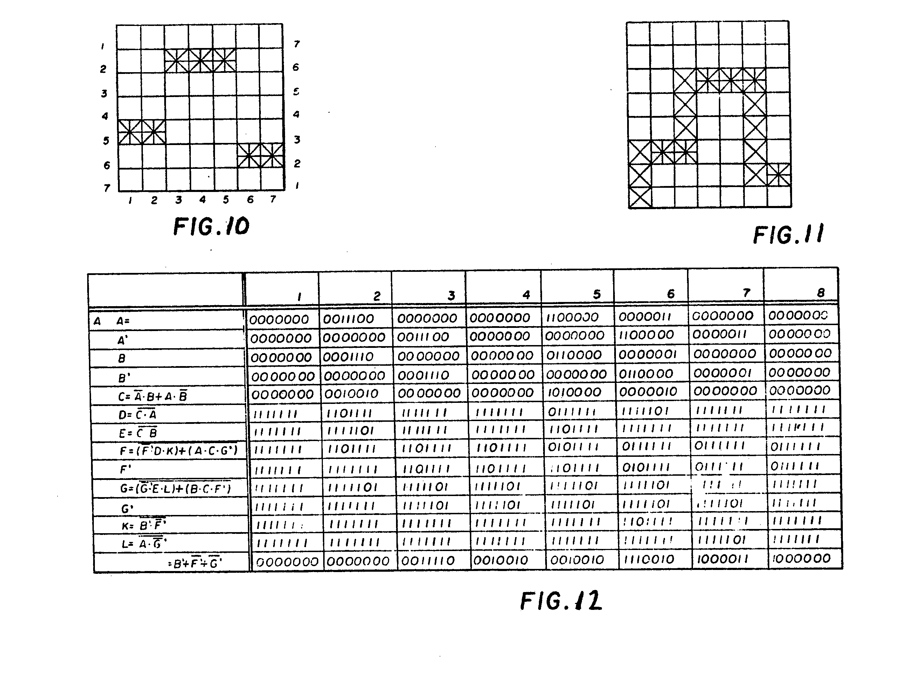

The circuit of Figure 9 can perhaps be most fully understood by following a set of data through it. The example which follows will outline how the circuit will transform the data points shown in Figure 10 into the continuous visual display shown in Figure 11. The example will show a 7×7 input array and a 7×8 scan line output array. These are much smaller arrays than would normally be used in practice and are chosen this small for simplicity of illustration. This data could be stored in a memory made up of seven storage elements (one for each of the seven resolution positions per scan line) each element having three bits of storage ($2^3=8$, so that each of the seven scan lines can be uniquely addressed). Thus a total of twenty-one bits of storage are used — much less than the forty-nine bits of storage that a 7×7 array of one bit memory elements would use. Figure 12 illustrates the signals at various labeled points in the above circuit during each of the eight scan lines. By way of convention, zeros are used to denote a low pulse and ones a high pulse. Although the term pulse will be used throughout, it is to be understood that a string of seven low pulses would be merely a continuous low voltage on the line during each clock pulse, and a series of high pulses would be actually a continuous high voltage on the line during the appropriate number of clock pulses.

Considering Figures 10, 11 and 12: Figure 10 can be regarded as seven memory words, each word capable of having any one of seven values. It will be seen that in the first scan line of Figure 10 there is no data, i.e. none of the data words has a value of seven. Accordingly, the input A to the circuit during the first scan line would be all low pulses. This data or lack of data would have no effect on the circuit and would produce an output of all low pulses.

In the second line of Figure 10, it will be seen that there are three bits of data which will produce the string of input data shown in the second column (scan line 2) of Figure 12. It will be seen that during the second scan line the inverting AND gate 116 produces a signal D which indicates the position for the rise line by having a low pulse in its third position, the position corresponding to the beginning of the line of data. Further, through AND-OR-INVERT gate 120, this position indication from signal D is also transferred to signal F. Similarly, signal E detects the position for a fall line and, through AND-OR-INVERT gate 140, transfers this information to signal G. Signals F and G are then stored in shift registers 130 and 150, respectively. The output, it will be seen, is actually one scan line delayed. The signals B, $\overline{F'}$, and $\overline{G'}$ will all be low. Accordingly, there will be no output displayed in the second scan line.

Looking to the third line of Figure 10, it will be seen that there is no data represented on that line. Accordingly, the input to the circuit will be a string of all low pulses as illustrated in Figure 12, column 3. It will be seen, then, that signals D and E will indicate no rise or fall lines. Signal F, however, is a composite, not only of the input from the signal D but from the recirculating line, through which the data in shift register 130 can be returned to the input of AND-OR-INVERT gate 120 and repeated in subsequent signals F. Similarly, the data in shift register 150 is recirculated onto subsequent signals G. It will be seen, then, that the output on line 154 will be high at the pulse positions, that B' is high, or $\overline{F'}$ is high, or $\overline{G'}$ is high. Thus, the data read in in scan line 2 is now displayed as the three blocks of line 3 of Figure 11 marked with a star. Also, the first rise line point is displayed as the square in line 3 of Figure 11 marked with an X. Further, it will be seen that the information concerning the rise and fall lines in signals F' and G' have been recirculated back into shift registers 130 and 150 respectively so that that information has been retained.

It will be seen that in Figure 10, the fourth scan line also has no data. Accordingly, the input to the circuit will again be a string of all low pulses. Again, there being no new data, signals D and E will generate no new rise or fall lines. The signals F' and G' which indicate the location of the rise and fall lines respectively will be recirculated back into their respective shift registers and retained. The output in this scan line is again high in the positions corresponding to pulses in any one of B'; $\overline{F'}$; or $\overline{G'}$. In this case, that would be a high pulse at the rise and fall line positions, which is to say, positions 3 and 6 respectively marked with an X in line 4 of Figure 11.

Going on to the fifth line of Figure 10 (column 5 of Figure 12), it will be seen that there are data points to be read in the first two positions. Thus, the input pulse to the circuit will be two high pulses in the first two positions. Because of the new input data, signal D will indicate a rise line position and signal E a fall line position. The signal F, it will be seen, will have the old rise line position recirculated back into it and have the new position from signal D added to it. This produces a new signal F for storage in shift register 130 which indicates two rise lines. The new fall line position indicated by signal E will not however, appear as part of signal G. It will be seen that signal G would have had this fall line added to it, except that the second half of the expression for G from AND gate 144 acts as a filter which filters out fall lines which are in the same position as a currently existing rise line. Thus, the new fall line indicated in signal E is not passed to signal G. Signal G has only the previous fall line from signal G' recirculated back into itself. The output for line 5 will again be high in those clock pulse positions corresponding to high pulses in any one of B', $\overline{F'}$, or $\overline{G'}$. In this case, that would again be only the rise and fall lines generated in the previous scan line in the third and sixth positions.

In line 6 of Figure 10, it will be seen that there are again two more data points to be read in. Signal D generates a rise line signal indication, but signal E, because the new data is at the end of the line, is unable to generate a possible fall line position. The new rise line in the fifth position of signal D is prohibited by AND gate 124 of AND-OR-INVERT gate 120 from being put into signal F. AND gate 124 prohibits formation of a rise line in the same position as an existing fall line. In this case, there already was a fall line in the sixth position and, accordingly the new rise line was filtered out. Gate 134 has also detected, the coincidence in the third position of a pulse of delayed input data, signal B', and an indication of a rise line in signal F', signal K, the output of gate 134, then goes low in the third position. Signal K in AND gate 122 of AND-OR-INVERT gate 120 acts to block the signal indicative of the rise line in the third position from being recirculated. Accordingly, the new signal F will only have a low pulse in the first position to indicate one rise line. Signal G is recirculated unaffected. The output again is high in those pulse positions corresponding to a high pulse in any one of signals B', $\overline{F}'$, or $\overline{G}'$. This produces the output shown by X's and stars in the sixth line of Figure 11.

In line 7, it will be seen that Figure 10 supplies no input data. Inverting AND gate 162 will detect that data read in the previous line had a high pulse in the sixth position and that signal G' indicated a fall line in the sixth position. Gate 162, through signal L, causes AND gate 142 to cut off the recirculation of this fall line. The output on line 154 then will have a high pulse in the first position from the recirculating rise line, a high pulse in the sixth position from the fall line which was cut off, and a high pulse in the seventh position from the high pulse input in line 6 in the sixth position.

There is no line 8 of Figure 10; accordingly, there would be no input data. There having been no input for two lines, shift register 158 is empty. Since the fall line was cut off in the previous line, shift register 150 has no data. The only output is from the recirculating rise line in the first position from shift register 130.

Thus, it can be seen that the circuit of Figure 9 connects horizontal line segments of single valued functions into a continuous line representation.

The above discussion has been in terms of horizontal lines of data. It will be appreciated that the discussion is just as relevant to individual data points. In working with discrete points of data, the circuit doubles each data point, i.e., puts it on two adjacent horizontal positions and connects subsequent data points with vertical lines. Within the resolution of the display device, this will accurately approximate a curve single valued in the scan direction of virtually any shape. For any waveform single valued in a direction parallel to the scan lines, the present invention generates all the necessary vertical lines to connect discrete data points into a continuous waveform. This invention is applicable to any x, y matrix type display not just cathode ray tubes. The invention is applicable to plasma display panels, all "television" type displays, electrostatic ink or thermal recorders which scan across the paper incrementing scan lines in step with paper motion, and ink jet recorders among others. Further, the present invention is capable of displaying a plurality of non-overlapping single value waveforms on the single cathode ray tube or other x, y type matrix. Under certain conditions, it is possible for the plurality of single value waveforms to touch or cross without disrupting the display, but in most situations touching or crossing would disrupt the display.

## Claims

1. A system for interpolating data to be displayed in a display matrix comprising a plurality of data display lines each comprised of a plurality of selectively addressable data display elements, the data being assembled in a plurality of lines of data to be displayed sequentially in respective data display lines of the display matrix and each line of data comprising the data to be displayed selectively in the plurality of data display elements of the respective data display line, said system comprising means (20, 26; 112, 114) arranged to derive additional data from said assembled data, and means (16, 44; 152, 134, 162) to incorporate said additional data into the assembled data to be displayed therewith in said display matrix, said additional data corresponding to data display elements such as to interpolate with data display elements corresponding to the assembled data so that when all the data is displayed, a logical continuum of addressed data display elements is provided between data display elements which are addressed by data of said assembled data and which are located in spaced apart display lines of the display matrix in positions which are next adjacent to one another relative to the respective displays lines, characterized in that said means for deriving additional data (20, 26; 112, 114) is operable sequentially on each said line of data for identifying for each said line of data the one or more positions therein whereat an addressed data display element would next adjoin a data display element not so addressed if the respective line of data were displayed in a data display line of the display matrix and for generating for each said line of data additional data representative of such identified positions, in that storage means (34; 130, 150) are provided for storing said generated data, and in that said means to incorporate said additional data into the assembled data comprises means (16; 52) operable sequentially on each said line of data to be displayed to incorporate therein the data from the storage means (34; 130, 150) and logic means (44; 134, 162) to inhibit such incorporation whenever an identified data display position represented by a generated data item bears a predetermined relationship with an addressed data display element position in the respective data line.

2. A system as claimed in claim 1, wherein for identifying said one or more positions the system comprises means (20; 112) for shifting each said line of data laterally by an amount corresponding to at least one data display element, and means (26; 114) for comparing the respective line of data and the shifted line of data to detect differences at locations corresponding to said positions.

3. A system as claimed in claim 2, wherein each of said lines of data comprises a pulse train of high and low pulses corresponding to the addressed and not addressed data display elements, said pulses being synchronized with clock pulses, wherein for identifying said positions each of said pulse trains is applied to delay means (20) adapted to generate a corresponding pulse train delayed by at least one clock pulse period and the respective pulse train is compared with the pulse train thus delayed by means of an exclusive OR gate (26) for generating a further pulse train having data components therein corresponding to said identified positions, and wherein said further pulse train is clocked into a shift register (34) arranged to provide an output for incorporation with the next succeeding data pulse train received by the system to be displayed therewith.

4. A system as claimed in claim 3, wherein said generated data representative of said identified positions is arranged to be entered into storage in a data line formatted correspondingly to said lines of data for incorporation with the respective line of data next to be displayed, and means (28) are provided for blocking such entry into storage of any item of such data in respect of which there is already an entry in the corresponding position of the storage means (34).

5. A system as claimed in claim 4, wherein the data line entered into said storage means (34) is re-entered therein for each successive one of the lines of data to be displayed, and said logic means (44) is arranged to block such re-entry in respect of any item of the data line entered into the storage means (34) which is in a position corresponding to or next adjoining a said identified position in the respective one of the lines of data to be displayed.

6. A system as claimed in claim 5, wherein the logic means (44) comprises first AND gate means (44) provided to block said re-entry in respect of data bits of the recirculating pulse train which coincide with data bits in the same portion in the then current input pulse train or in such input pulse train delayed by at least one clock pulse period, and second AND gate means (28) provided to block such re-entry in respect of data bits of the re-circulating pulse train which coincide with any of said data components of said further pulse train.

7. A system as claimed in claim 1 or 2, wherein said means (112, 114) provided for identifying said one or more positions is coupled to first means (116) for producing a signal indicative of a starting position of the data corresponding to the position in a line of data of an addressed data display element which is immediately preceded by a data display element which is not so addressed and to second means (118) for producing a signal indicative of a stopping position of the data corresponding to the position in a line of data of an addressed data display element which is immediately followed by a data display element which is not so addressed, and wherein said storage means includes a first storage means (130) for storing the signals indicative of the starting positions of data in a line of data and a second storage means (150) for storing the signals indicative of the stopping positions of data in a line of data, the outputs of said first and second storage means being coupled to said means (152) for incorporating the data in said storage means (130, 150) with the data to be displayed.

8. A system as claimed in claim 7, wherein the output of said starting position storage means (130) is coupled to the input thereof for recirculating output signals from the starting position storage means back into its input, the output of said stopping position storage means (150) is coupled to the input thereof for re-circulating output signals from the stopping position storage means back into its input, and wherein said logic means comprises first blocking means (122, 126) controlled by said means (118) for producing a signal indicative of the stopping position for selectively blocking said recirculation of data through the starting position storage means (130) and second blocking means (142, 146) controlled by said means (116) for producing a signal indicative of the starting position for selectively blocking said recirculation of data through the stopping position storage means (150).

9. A system as claimed in claim 8, wherein said logic means further includes third blocking means (124) controlled by the recirculation of data through the stopping position storage means (150) and arranged for selectively blocking passage of signals from the start position detecting means (116) to said start position storage means (130), and fourth blocking means (144) controlled by the recirculation of data through the starting position storage means (130) and arranged for selectively blocking the passage of signals from said stopping position detecting means (118) to said stopping position storage means (150).

10. A system according to any of the preceding claims in combination with a memory containing said assembled data and a said display matrix.

**Patentansprüche**

1. Schaltungsanordnung zur Interpolation von in einer Abbildungsmatrix abzubildenden Daten, bestehend aus Datenabbildungszeilen, von denen jede aus selektiv addressierbaren Datenabildungselementen aufgebaut ist, wobei die Daten aus einer Anzahl Datenzeilen zusammengesetzt sind, die in entsprechenden Datenabbildungszeilen der Abbildungsmatrix sequentiell abgebildet werden, und wobei jede Datenzeile Daten umfaßt, die in der Anzahl Datenabbildungselementen der entsprechenden Datenabbildungszeile sequentiell abgebildet werden, welche Anordnung eine Einrichtung (20, 26; 112, 114) zur Ableitung von Zusatzdaten aus den zusammengesetzten Daten aufweist, und ferner Einrichtungen (16, 44; 152, 134, 162) zum Einsetzen der Zusatzdaten in die mit diesen in der Abbildingsmatrix abzubildenden zusammengesetzten Daten, wobei die Zusatzdaten Datenabbildungs elementen derart entsprechen, daß sie zwischen Datenabbildingselementen, die zusammengesetzten Daten entsprechen, eingeschoben werden, so daß, wenn alle Daten abgebildet werden, ein logisches Kontinuum addressierter Datenabbildungselemente zwischen Datenabbildingselementen gebildet wird, die von Daten der zusammengesetzten Daten addressiert werden und die in voneinander getrennten Zwischenräumen der Abbildungsmatrix an Stellen liegen, die einander bezüglich der entsprechenden Abbildungszeilen benachbart sind, dadurch gekennzeichnet, daß die Einrichtung (20, 26; 112, 114) zur Ableitung von Zusatzdaten auf jeder Datenzeile sequentiell betätigbar ist, um für jede solche Datenzeile die Stelle bzw. die Stellen darin zu identifizieren, an der bzw. an denen ein addressiertes Datenabbildungselement einem nicht so adressierten Datenabbildungselement nächst benachbart ist, wenn die entsprechende Datenzeile in einer Datenabbildungszeile der Abbildungsmatrix abgebildet wird, und außerdem betätigbar ist, um für jede solche Datenzeile Zusatzdaten zu erzeugen, die für diese identifizierten Stellen charakteristisch sind, daß ferner Speichereinrichtungen (34; 130, 150) vorgesehen sind, um die erzeugten Daten zu speichern, und daß die Einrichtungen zum Einsetzen der Daten in die zusammengesetzten Daten Glieder (16; 52) aufweisen, die auf jeder solchen abzubildenden Datenzeile sequentiell betätigbar sind, um die Daten aus den Speichereinrichtungen (34; 130, 150) aufzunehmen, und ferner Logikglieder (44, 134, 162) aufweisen, um solch eine Aufnahme zu sperren, wann immer eine identifizierte Datenwiedergabestelle, die von einem erzeugten Datenwert wiedergegeben wird, eine vorbestimmte Beziehung zu einer adressierten Datenabbildungselement-Stelle in der entsprechenden Datenzeile hat.

2. Schaltungsanordnung nach Anspruch 1, dadurch gekennzeichnet, daß zur Identifizierung der einen Stelle oder der mehreren Stellen eine Einrichtung (20; 112) zur seitlichen Verschiebung jeder solchen Datenzeile um eine Größe entsprechend wenigstens einem Datenabbildungselement vorgesehen ist, und ferner eine Einrichtung (26; 114) zum Vergleich der entsprechenden Datenzeile und der verschobenen Datenzeile, um die Unterschiede an, diesen Stellen entsprechenden Positionen zu ermitteln.

3. Schaltungsanordnung nach Anspruch 2, dadurch gekennzeichnet, daß jede Datenzeile eine Impulsfolge hoher und niedriger Impulse entsprechend den adressierten und nicht adressierten Datenabbildungselementen aufweist, wobei die Impulse mit Taktimpulsen synchronisiert sind, daß zur Identifizierung der Stellen die Impulsfolgen auf eine Verzögerungseinrichtung (20) gegeben werden, die eine entsprechende Impulsfolge erzeugen kann, welche um wenigstens eine Taktimpulsperiode verzögert ist, und daß die entsprechende Impulsfolge mit der so verzögerten Impulsfolge durch ein EXKLUSIV-ODER-Gatter (26) verglichen wird, um eine weitere Impulsfolge zu erzeugen, die Datenkomponenten entsprechend den identifizierten Stellen hat, und daß die weitere Impulsfolge taktmäßig in ein Schieberegister (34) eingegeben wird, welches ein Ausgangssignal zur Aufnahme in die nächstfolgende Datenimpulsfolge erzeugt, die von der Schaltungsanordnung zur Abbildung mit dieser empfangen wird.

4. Schaltungsanordnung nach Anspruch 3, dadurch gekennzeichnet, daß die erzeugten, für die identifizierten Stellen charakteristischen Daten so angeordnet werden, daß sie zur Speicherung in eine Datenzeile eingegeben werden können, welche ein Format entsprechend den Datenzeilen zur Aufnahme in die entsprechende, nächstfolgend abzubildende Datenzeile hat, und daß eine Einrichtung (28) vorgesehen ist, um die Speicherung jedes Wertes solcher Daten zu sperren, bezüglich derer bereits eine Eingabe an der entsprechenden Stelle der Speichereinrichtung (34) vorhanden ist.

5. Schaltungsanordnung nach Anspruch 4, dadurch gekennzeichnet, daß die in die Speichereinrichtung (34) eingegebene Datenzeile bei jeder folgenden der abzubildenden Datenzeilen erneut eingegeben wird, und daß das Logikglied (44) die erneute Eingabe bezüglich jedes Wertes der Datenzeile, die in die Speichereinrichtung (34) eingegeben wird, sperrt, der sich an einer Stelle entsprechend der oder nächst benachbart zu der identifizierten Stelle in der entsprechenden der abzubildenden Datenzeilen befindet.

6. Schaltungsanordnung nach Anspruch 5, dadurch gekennzeichnet, daß das Logikglied (44) ein erstes UND-Gatter-Glied (44) aufweist, das die erneute Eingabe bezüglich Datenbits der umlaufenden Impulsfolge sperrt, die mit Datenbits in dem gleichen Teil in der dann laufenden Eingangsimpulsfolge oder in solch einer Eingangsimpulsfolge übereinstimmt, die um wenigstens eine Taktimpulsperiode verzögert ist, und ein zweites UND-Gatter-Glied (28) aufweist, das solch ein erneute Eingabe bezüglich Datenbits in der umlaufenden Impulsfolge sperrt, die mit irgendeiner der Datenkomponenten der weiteren Impulsfolge übereinstimmt.

7. Schaltungsanordnung nach Anspruch 1 oder 2, dadurch gekennzeichnet, daß die Einrichtung (112, 114) zur Identifizierung der einen oder mehreren Stellen mit einem ersten Glied (116) zur Erzeugung eines Signals verbunden ist, das eine Startstelle der Daten entsprechend der Stelle in einer Datenzeile eines adressierten Datenabbildingselementes angibt, dem unmittelbar ein Datenabbildingselement vorangeht, das nicht so adressiert ist, und ferner mit einem zweiten Glied (118) zur Erzeugung eines Signals verbunden ist, das eine Stopstelle der Daten entsprechend der Stelle in einer Datenzeile eines adressierten Datenabbildungselementes angibt, der unmittelbar ein Datenabbildungselement folgt, das nicht so adressiert ist, und daß die Speichereinrichtung einen ersten Speicher (130) zur Speicherung der Signale aufweist, welche die Startstellen von Daten in einer Datenzeile angeben, ferner einen zweiten Speicher (150) aufweist, um die Signale zu speichern, welche die Stopstellen von Daten in einer Datenzeile angeben, wobei die Ausgänge des ersten und zweiten Speichers mit der Einrichtung (152) zur Aufnahme der Daten in der Speichereinrichtung (130, 150) zusammen mit den abzubildenden Daten verbunden ist.

8. Schaltungsanordnung nach Anspruch 7, dadurch gekennzeichnet, daß der Ausgang des Startstellen-Speichers (130) mit dessen Eingang verbunden ist, um die Ausgangssignale des Startstellen-Speichers zu seinem Eingang zurückzuführen, daß der Ausgang des Stopstellen-Speichers (150) mit dessen Eingang verbunden ist, um die Ausgangssignale von dem Stopstellen-Speicher zu seinem Eingang zurückzuführen, und daß das Logikglied ein erstens Sperrglied (122, 126) aufweist, das von dem Glied (118) zur Erzeugung eines Signals gesteuert wird, welches die Stopstelle angibt, um die Rückführung von Daten durch den Startstellen-Speicher (130) selektiv zu sperren, und daß ein zweites Sperrglied (142, 146) vorhanden ist, das von der Einrichtung (116) zur Erzeugung eines Signals gesteuert wird, welches die Startstelle angibt, um die Rückführung von Daten durch den Stopstellen-Speicher (150) selektiv zu sperren.

9. Schaltungsanordnung nach Anspruch 8, dadurch gekennzeichnet, daß das Logikglied ferner ein drittes Sperrglied (124) aufweist, das durch die Rückführung von Daten durch den Stopstellen-Speicher (150) gesteuert wird, und so ausgebildet ist, daß es den Durchgang von Signalen von der Startstellen-Ermittlungseinrichtung (116) zu dem Startstellen-Speicher (130) selektiv sperrt, und ferner ein viertes Sperrglied (144) vorhanden ist, das durch die Rückführung von Daten durch den Startstellen-Speicher (130) gesteuert wird, und so ausgebildet ist, daß es den Durchgang von Signalen von der Stopstellen-Ermittlungseinrichtung (118) zu dem Stopstellen-Speicher (150) selektiv sperrt.

10. Schaltungsanordnung nach einem der vorhergehenden Ansprüche, gekennzeichnet durch die Kombination mit einem Speicher, der die zusammengesetzten Daten und die Abbildungsmatrix enthält.

**Revendications**

1. Système d'interpolation de données à afficher dans une matrice d'affichage comprenant plusieurs lignes d'affichage de données constituées chacune par plusieurs éléments d'affichage de données adressables sélectivement, les données étant assemblées en plusieurs lignes de données à afficher séquentiellement dans des lignes d'affichage de données respectives de la matrice d'affichage et chaque ligne de données contenant les données à afficher sélectivement dans les plusieurs éléments d'affichage de données de la ligne d'affichage de données respectives, ledit système comprenant un dispositif (20, 26; 112, 114) disposé pour dériver des données supplémentaires à partir desdites données assemblées et un dispositif (16, 44; 152, 134, 162) pour incorporer lesdites données supplémentaires dans les données assemblées pour les afficher avec elles dans ladite matrice d'affichage, lesdites données supplémentaires correspondant aux éléments d'affichage de données de manière à interpoler avec des éléments d'affichage de données correspondant aux données assemblées, afin que toutes les données soient affichées, une série logique continue d'éléments d'afficharge de données adressés étant prévus entre les éléments d'affichage de données qui sont adressés par des données desdites données assemblées et qui sont situés dans des lignes d'affichage espacées de la matrice d'affichage, dans des positions qui sont immédiatement adjacentes l'une de l'autre par rapport aux lignes d'afficharge respectives, caractérisé en ce que ledit dispositif qui dérive des données supplémentaires (20, 26; 112, 114) fonctionnent séquentiellement sur chacune desdites lignes de données pour identifier pur chaque ligne de données une ou plusieurs positions dans lesquelles un élément d'affichage de données adressé serait immédiatement voisin d'un élément d'affichage de données non adressé si la ligne respective de données était affichée dans une ligne d'afficharge de données de la matrice d'affichage, et pour produire pour chacune desdites lignes de données des données supplémentaires représentant ces positions identifiées, en ce qu'un dispositif de mémorisation (34; 130, 150) est prévu pour mémoriser lesdites données produites et en ce que le dispositif qui incorpore lesdites données supplémentaires dans les données assemblées comporte un dispositif (16; 52) fonctionnant séquentiellement sur chacune desdites lignes de données à afficher pour y incorporer les données provenant du dispositif de mémorisation (34; 130, 150) et un dispositif logique (44; 134, 62) pour inhiber cette incorporation quand une position d'affichage de données identifiée représentée par un article de données produit répond à une relation prédéterminée avec une position d'éléments d'affichage de données adressée dans la ligne de données respectives.

2. Système selon la revendication 1, dans lequel pour identifier lesdites une ou plusieurs positions, le système comporte un dispositif (20; 112) pour décaler chaque ligne de données latéralement d'un valeur correspondant à au moins un élément d'affichage de données et un dispositif (26; 114) pour comparer la ligne respective de données et la ligne décalée de données afin de détecter des différences dans des positions correspondant auxdites positions.

3. Système selon la revendication 2, dans lequel chacune desdites lignes de données consiste en un train d'impulsions de niveau haut et de niveau bas correspondant aux éléments d'affichage de données adressés et non adressés, lesdites impulsions étant synchronisées avec des impulsions d'horloge, dans lequel pour identifier lesdites positions, chacun desits trains d'impulsions est appliqué à un dispositif à retard (20) agencé pour produire un train d'impulsions correspondant retardé d'au moins une période d'impulsions d'horloge et le train d'impulsions respectif est comparé avec le train d'impulsions ainsi retardé au moyen d'une porte OU-EXCLUSIF 26 afin de produire un autre train d'impulsions contenant des composantes de données correspondant auxdites positions identifiées et dans lequel ledit autre train d'impulsions est introduit par horloge dans un registre à décalage (34) agencé pour produire une sortie pour l'incorporation dans le train d'impulsions de données suivant immédiatement reçues par le système, pour être visualisées avec lui.

4. Système selon la revendication 3, dans lequel lesdites données produites représentant lesdites positions identifiées sont agencées pour être introduites en mémoire dans une ligne de données mise en format en correspondance avec lesdites lignes de données pour l'incorporation avec la ligne respective de données suivantes à afficher, et un dispositif (28) étant prévu pour bloquer cette entrée en mémoire d'un article de ces données par rapport auquel il y a déjà une entrée dans la position correspondante du dispositif de mémorisation (34).

5. Système selon la revendication 4, dans lequel la ligne de données introduites dans ledit dispositif de mémorisation (34) y est introduite à nouveau pour chacune successive des lignes de données à afficher, ledit dispositif logique (44) étant agencé pour bloquer cette nouvelle entrée pour tout article de la ligne de données introduite dans le dispositif de mémorisation (34) qui se trouve dans une position correspondant ou immédiatement voisine de ladite position identifiée dans l'une respective des lignes de données affichées.

6. Système selon la revendication 5, dans lequel le dispositif logique (44) comporte une première porte ET (44) prévue pour bloquer ladite nouvelle entrée en ce qui concerne des bits de données du train d'impulsions en recirculation coïncidant avec des bits de données dans la même partie dans le train d'impulsions d'entrée en cours ou dans le train d'impulsions d'entrée retardé d'au moins une période d'impulsions d'horloge et une seconde porte ET (28) prévue pour bloquer cette nouvelle entrée en ce qui concerne des bits de données du train d'impulsions en recirculation coïncidant avec l'un quelconque desdites composantes de données dudit autre train d'impulsions.

7. Système selon la revendication 1 ou 2, dans lequel ledit dispositif (112, 114) prévu pour identifier lesdites une ou plusieurs positions est couplé avec le premier dispositif (116) pour produite un signal indiquant une position de départ des données correspondant à la position dans une ligne donnée d'un élément d'affichage de données adressé qui est immédiatement précédé par un élément d'affichage de données qui n'est pas adressé et avec le second dispositif (118) pour produire un signal indiquant une position d'arrêt des données correspondant à la position dans une ligne de données d'un élément d'affichage de données adressé qui est immédiatement suivi par un élément d'affichage de données qui n'est pas adressé, et dans lequel ledit dispositif de mémorisation comporte un premier dispositif de mémorisation (130) pour mémoriser les signaux indiquant les positions de départ de données dans une ligne de données et un second dispositif de mémorisation (150) pour mémoriser les signaux indiquant les positions d'arrêt de données dans une ligne de données, les sorties desits premier et second dispositifs de mémorisation étant couplés avec ledit dispositif (152) pour incorporer les données dans ledit dispositif de mémorisation (130, 150) avec les données à afficher.

8. Système selon la revendication 7, dans lequel la sortie dudit dispositif de mémorisation (130) de position de départ est couplée avec son entrée pour la recirculation de signaux de sortie du dispositif de mémorisation de position de départ dans son entrée, la sortie dudit dispositif de mémorisation (150) de position d'arrêt étant couplée avec son entrée pour la recirculation des signaux de sortie du dispositif de mémorisation de position d'arrêt en retour à son entrée, et dans lequel ledit dispositif logique comporte un premier dispositif de blocage (122, 126) commandé par ledit dispositif (18) pour produire un signal indiquant la position d'arrêt pour bloquer sélectivement ladite recirculation des données dans ledit dispositif de mémorisation (130) de position de départ et un second dispositif de blocage (142, 146) commandé par ledit dispositif (116) pour produire un signal indiquant la position de départ pour bloquer sélectivement ladite recirculation de données par le dispositif de mémorisation (150) de position d'arrêt.

9. Système selon la revendication 8, dans lequel ledit dispositif logique comporte un troisème dispositif de blocage (124) commandé par la recirculation de données par le dispositif de mémorisation (150) de position d'arrêt et agencé pour bloquer sélectivement le passage de signaux depuis le dispositif (116) de détection de position de départ vers le dispositif (130) de mémorisation de position de départ et un quatrième dispositif de blocage (144) commandé par la recirculation de données par le dispositif de mémorisation (130) de position de départ et agencé pour bloque sélectivement le passage de signaux depuis ledit dispositif (118) de détection de détection de position d'arrêt vers ledit dispositif de mémorisation (150) de position d'arrêt.

10. Système selon l'une quelconque des revendications précédentes, en combinaison avec une mémoire qui contient lesdites données assemblées et ladite matrice d'affichage.

$$D + D' + A + B = V$$

FIG. 1

FIG. 2

1

FIG.3

FIG.4

FIG.5

FIG.6

FIG.7

FIG. 8

FIG.9

FIG.10

FIG.11

| | 1 | 2 | 3 | 4 | 5 | 6 | 7 | 8 |
|---|---|---|---|---|---|---|---|---|
| A    A= | 0000000 | 0011100 | 0000000 | 0000000 | 1100000 | 0000011 | 0000000 | 0000000 |
| A' | 0000000 | 0000000 | 0011100 | 0000000 | 0000000 | 1100000 | 0000011 | 0000000 |
| B | 0000000 | 0001110 | 0000000 | 0000000 | 0110000 | 0000001 | 0000000 | 0000000 |
| B' | 0000000 | 0000000 | 0001110 | 0000000 | 0000000 | 0110000 | 0000001 | 0000000 |
| $C = \overline{A} \cdot B + A \cdot \overline{B}$ | 0000000 | 0010010 | 0000000 | 0000000 | 1010000 | 0000010 | 0000000 | 0000000 |
| $D = \overline{C} \cdot A$ | 1111111 | 1101111 | 1111111 | 1111111 | 0111111 | 1111101 | 1111111 | 1111111 |
| $E = \overline{C} \ \overline{B}$ | 1111111 | 1111101 | 1111111 | 1111111 | 1101111 | 1111111 | 1111111 | 1111111 |
| $F = (F' \cdot D \cdot K) + (A \cdot C \cdot G')$ | 1111111 | 1101111 | 1101111 | 1101111 | 0101111 | 0111111 | 0111111 | 0111111 |
| F' | 1111111 | 1111111 | 1101111 | 1101111 | 1101111 | 0101111 | 0111111 | 0111111 |
| $G = (\overline{G} \cdot E \cdot L) + (B \cdot C \cdot F')$ | 1111111 | 1111101 | 1111101 | 1111101 | 1111101 | 1111101 | 111111 | 1111111 |
| G' | 1111111 | 1111111 | 1111101 | 1111101 | 1111101 | 1111101 | 1111101 | 1111111 |
| $K = \overline{B' \cdot F'}$ | 1111111 | 1111111 | 1111111 | 1111111 | 1111111 | 1101111 | 1111111 | 1111111 |
| $L = \overline{A \cdot \overline{G}'}$ | 1111111 | 1111111 | 1111111 | 1111111 | 1111111 | 1111111 | 1111101 | 1111111 |
| $= B + \overline{F} + \overline{G}$ | 0000000 | 0000000 | 0011110 | 0010010 | 0010010 | 1110010 | 1000011 | 1000000 |

FIG.12